# NEW EUROPEAN PATENT SPECIFICATION

(11) **EP 0 878 270 B2**
(45) Date of publication and mention of the opposition decision: **19.03.2014**
(45) Mention of the grant of the patent: 27.07.2005
(21) Application number: 98303723.5
(22) Date of filing: 12.05.1998
(51) Int. Cl.: B24D 13/14, B24B 37/04

(54) **Polishing pad having a grooved pattern for use in a chemical mechanical polishing apparatus**
Polierkissen mit Rillenmuster zur Verwendung in einer chemisch-mechanischen Poliervorrichtung
Tampon de polissage pourvu d'un profil de rainures destiné à l'utilistion dans un dispositif de polissage mécano-chimique

(30) Priority: 15.05.1997 US 856948; 06.01.1998 US 3315
(43) Date of publication of application: 18.11.1998
(73) Proprietor: Applied Materials, Inc., Santa Clara, CA 95054 (US)
(72) Inventor: Osterheld, Tom, Mountain View, California 94040 (US); Ko, Sen-Hou, Cupertino, California 95014 (US); Bennett, Doyle Edward, Santa Clara, California 95051 (US); Redeker, Fred C., Fremont, California 94539 (US); Addiego, Ginetto, Berkeley, California 94709 (US)
(74) Representative: Boult Wade Tennant

(56) References cited:
- EP-A- 0 674 972
- EP-A1- 0 737 547
- EP-A2- 0 439 124
- WO-A-90/14926
- JP-A- H05 146 969
- JP-A- S61 182 753
- US-A- 5 131 190
- US-A- 5 212 910
- US-A- 5 216 843
- US-A- 5 297 364
- US-A- 5 329 734
- US-A- 5 421 769
- US-A- 5 489 233
- US-A- 5 527 215
- US-A- 5 578 362
- US-A- 5 690 540
- ALI ET AL: 'Chemical-mechanical polishing of interlayer dielectric: A review' SOLID STATE TECHNOLOGY October 1994, pages 63 - 68
- KOLENKOW AND NAGAHARA: 'Chemical-Mechanical Wafer Polishing and Planarization in Batch Systems' SOLID STATE TECHNOLOGY June 1992, pages 112 - 114
- TOLLES ET AL.: 'Performance of the applied materials cmp system for inter-level dielectric polishing processes using single step and multi-step process sequences.' CMP _ MIC CONFERENCE February 1996, pages 201 - 208
- PETER A. BURKE: 'Semi-Empirical Modelling of SiO2 Chemical-Mechanical Polishing Planarization.' VMIC CONFERENCE June 1991, pages 379 - 384
- RENTELN ET AL.: 'Characterization of Mechenical Planarization Processes' VMIC CONFERENCE June 1990, pages 57 - 63
- WELING ET AL.: 'Improving CMP Performance using Grooved Polishing Pads' CMP - MIC CONFERENCE February 1996, pages 40 - 46
- 'Rodel IC1400 CMP pad' RODEL BROCHURE June 1996,
- 'Rodel Glass Polishing Systems Pads. Template Assemblies' RODEL BROCHURE January 1992,
- 'Glass Polishing Pads' RODEL BROCHURE January 1993,

## Description

The present invention relates generally to a polishing pad, as per the preamble of claim 1. Such a pad is disclosed in US-A-5,578,362.

Integrated circuits are typically formed on substrates, particularly silicon wafers, by the sequential deposition of conductive, semiconductive or insulative layers. After each layer is deposited, the layer is etched to create circuitry features. As a series of layers are sequentially deposited and etched, the outer or uppermost surface of the substrate, i.e., the exposed surface of the substrate, becomes increasingly non-planar. This non-planar outer surface presents a problem for the integrated circuit manufacturer. Therefore, there is a need to periodically planarize the substrate surface to provide a flat surface.

Chemical mechanical polishing (CMP) is one accepted method of planarization. This method typically requires that the substrate be mounted on a carrier or polishing head. The exposed surface of the substrate is then placed against a rotating polishing pad. The carrier head provides a controllable load, i.e., pressure, on the substrate to push it against the polishing pad. In addition, the carrier head may rotate to provide additional motion between the substrate and polishing surface.

A polishing slurry, including an abrasive and at least one chemically-reactive agent, may be supplied to the polishing pad to provide an abrasive chemical solution at the interface between the pad and the substrate. CMP is a fairly complex process, and it differs from simple wet sanding. In a CMP process, the reactive agent in the slurry reacts with the outer surface of the substrate to form reactive sites. The interaction of the polishing pad and abrasive particles with the reactive sites on the substrate results in polishing of the substrate.

An effective CMP process not only provides a high polishing rate, but also provides a substrate surface which is finished (lacks small-scale roughness) and flat (lacks large-scale topography). The polishing rate, finish and flatness are determined by the pad and slurry combination, the relative speed between the substrate and pad, and the force pressing the substrate against the pad. The polishing rate sets the time needed to polish a layer. Because inadequate flatness and finish can create defective substrates, the selection of a polishing pad and slurry combination is usually dictated by the required finish and flatness. Given these constraints, the polishing time needed to achieve the required finish and flatness sets the maximum throughput of the CMP apparatus.

A recurring problem in CMP is non-uniformity of the polishing rate across the surface of the substrate. One source of this non-uniformity is the so-called "edge-effect", i.e., the tendency for the substrate edge to be polished at a different rate than the center of the substrate. Another source of non-uniformity is termed the "center slow effect", which is the tendency of center of the substrate to be underpolished. These non-uniform polishing effects reduce the overall flatness of the substrate and the substrate area suitable for integrated circuit fabrication, thus decreasing the process yield.

Another problem relates to slurry distribution. As indicated above, the CMP process is fairly complex, requiring the interaction of the polishing pad, abrasive particles and reactive agent with the substrate to obtain the desired polishing results. Accordingly, ineffective slurry distribution across the polishing pad surface provides less than optimal polishing results. Polishing pads used in the past have included perforations about the pad. These perforations, when filled, distribute slurry in their respective local regions as the polishing pad is compressed. This method of slurry distribution has limited effectiveness, since each perforation in effect acts independently. Thus, some of the perforations may have too little slurry, while others may have too much slurry. Furthermore, there is no way to directly channel the excess slurry to where it is most needed.

Another problem is "glazing" of the polishing pad. Glazing occurs when the polishing pad is heated and compressed in regions where the substrate is pressed against the pad. The peaks of the polishing pad are pressed down and the pits are filled up, so the polishing pad surface becomes smoother and less abrasive. As a result, the polishing time increases. Therefore, the polishing pad surface must be periodically returned to an abrasive condition, or "conditioned", to maintain a high throughput.

In addition, during the conditioning process, waste materials produced by conditioning the pad may fill or clog the perforations in the pad. Perforations clogged with such waste materials do not hold slurry effectively, thereby reducing the effectiveness of the polishing process.

An additional problem associated with filled or clogged pad perforations relates to the separation of the polishing pad from the substrate after polishing has been completed. The polishing process produces a high degree of surface tension between the pad and the substrate. The perforations decrease the surface tension by reducing the contact area between the pad and the substrate. However, as the perforations become filled or clogged with waste material, the surface tension increases, making it more difficult to separate the pad and the substrate. As such, the substrate is more likely to be damaged during the separation process.

Yet another problem in CMP is referred to as the "planarizing effect". Ideally, a polishing pad only polishes peaks in the topography of the substrate. After a certain period of polishing, the areas of these peaks will eventually be level with the valleys, resulting in a substantially planar surface. However, if a substrate is subjected to the "planarizing effect", the peaks and valleys will be polished simultaneously. The "planarizing effect" results from the compressible nature of the polishing pad in response to point loading. In particular, if the polishing pad is too flexible, it will deform and contact a large surface area of the substrate, including both the peaks and the valleys in the substrate surface.

Accordingly, it would be useful to provide a CMP apparatus which ameliorates some, if not all, of these problems.

The present invention is directed to a polishing pad for polishing a substrate in a chemical mechanical polishing system as disclosed in claim 1.

Advantages of the invention include the following. The polishing pad provides improved polishing uniformity. The grooves of the polishing pad provide an effective way to distribute slurry across the pad. The grooves are sufficiently wide that waste material produced by the conditioning process can be flushed from the grooves. The polishing pad is sufficiently rigid to avoid the "planarizing effect". The polishing pad's relatively deep grooves also improve the pad lifetime.

Other features and advantages will be apparent from the following description, with reference to the accompanying drawings, in which Figs. 5 to 16 do not fall within the scope of claim 1.
FIG. 1 is a schematic exploded perspective view of a chemical mechanical polishing apparatus.
FIG. 2 is a schematic cross-sectional view of a carrier head and a polishing pad.
FIG. 3 is a schematic top view of a polishing pad having concentric circular grooves in accordance with the present invention.
FIG. 4 is a schematic cross-sectional view of the polishing pad of FIG. 3 along line 4-4.
FIG. 5 is a schematic top view of a polishing pad using a spiral groove.
FIG. 6 is a schematic top view of a polishing pad in accordance with the present invention having regions of different groove spacing.
FIG. 7 is a cross-sectional view of the polishing pad of FIG. 6 along line 7-7.
FIG. 8 is a schematic top view of a polishing pad having regions with different groove widths.
FIG. 9 is a cross-sectional view of the polishing pad of FIG. 8 along line 9-9.
FIG. 10 is a schematic top view of a polishing pad having regions with different groove widths and different groove spacing.
FIG. 11 is a cross-sectional view of the polishing pad of FIG. 10 along line 11-11.
FIG. 12 is a schematic top view of a polishing pad having a spiral groove and regions of different groove pitch.
FIG. 13 is a schematic top view of a polishing pad having concentric circular grooves and serpentine grooves.
FIG. 14 is a schematic top view of a polishing pad having circular grooves with different radial centers.
FIG. 15 is a schematic top view of a polishing pad having concentric circular grooves and groove arc segments.
FIG. 16 is a schematic top view of a polishing pad having both concentric circular grooves and a spiral groove.

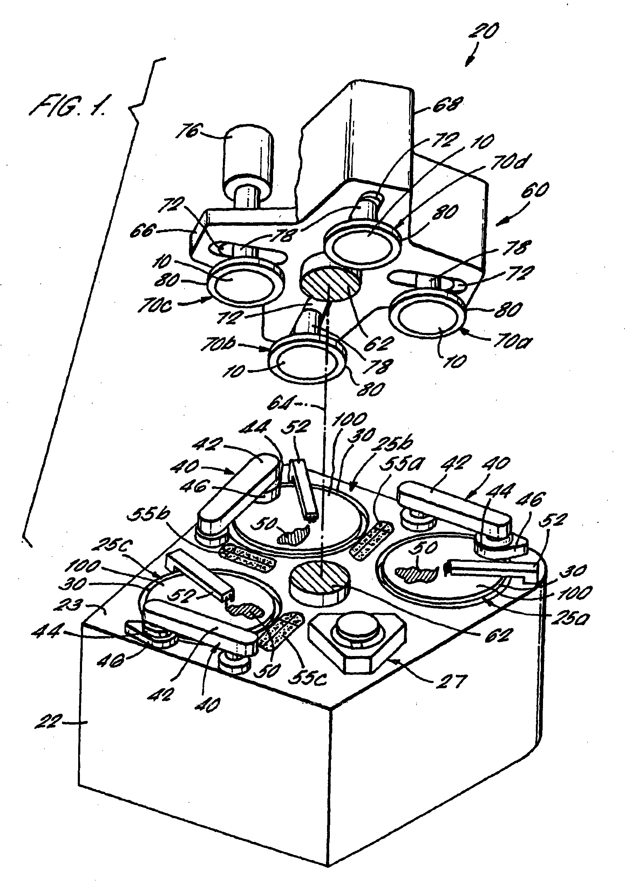

Referring to FIG. 1, one or more substrates 10 will be polished by a chemical mechanical polishing apparatus 20. A complete description of polishing apparatus 20 may be found in U.S. Patent No. 5,738,574. Polishing apparatus 20 includes a lower machine base 22 with a table top 23 mounted thereon and a removable outer cover (not shown) . Table top 23 supports a series of polishing stations 25a, 25b and 25c, and a transfer station 27. Transfer station 27 forms a generally square arrangement with the three polishing stations 25a, 25b and 25c. Transfer station 27 serves multiple functions, including receiving individual substrates 10 from a loading apparatus (not shown), washing the substrates, loading the substrates into carrier heads (to be described below), receiving the substrates from the carrier heads, washing the substrates again, and finally, transferring the substrates back to the loading apparatus.

Each polishing station includes a rotatable platen 30 on which is placed a polishing pad 100. If substrate 10 is an "eight-inch" (200 millimeter) or "twelve-inch" (300 millimeter) diameter disk, then platen 30 and polishing pad 100 will be about twenty inches (500 mm) in diameter. Platen 30 may be a rotatable aluminum or stainless steel plate connected to a platen drive motor (not shown). For most polishing processes, the platen drive motor rotates platen 30 at thirty to two hundred revolutions per minute, although lower or higher rotational speeds may be used.

Each polishing station 25a-25c may further include an associated pad conditioner apparatus 40. Each pad conditioner apparatus 40 has a rotatable arm 42 holding an independently-rotating conditioner head 44 and an associated washing basin 46. The conditioner apparatus maintains the condition of the polishing pad so it will effectively polish any substrate pressed against it while it is rotating.

A slurry 50 containing a reactive agent (e.g., deionized water for oxide polishing), abrasive particles (e.g., silicon dioxide for oxide polishing) and a chemically-reactive catalyzer (e.g., potassium hydroxide for oxide polishing) is supplied to the surface of polishing pad 100 by a combined slurry/rinse arm 52. The slurry/rinse arm may include two or more slurry supply tubes to provide slurry to the surface of the polishing pad. Sufficient slurry is provided to cover and wet the entire polishing pad 100. Slurry/rinse arm 52 also includes several spray nozzles (not shown) which provide a high-pressure rinse of polishing pad 100 at the end of each polishing and conditioning cycle.

Two or more intermediate washing stations 55a and 55b may be positioned between neighboring polishing stations 25a, 25b and 25c. The washing stations rinse the substrates as they pass from one polishing station to another.

A rotatable multi-head carousel 60 is positioned above lower machine base 22. Carousel 60 is supported by a center post 62 and is rotated thereon about a carousel axis 64 by a carousel motor assembly located within base 22. Center post 62 supports a carousel support plate 66 and a cover 68. Carousel 60 includes four carrier head systems 70a, 70b, 70c, and 70d. Three of the carrier head systems receive and hold substrates, and polish them by pressing them against polishing pads 100 on platens 30 of polishing stations 25a-25c. One of the carrier head systems receives a substrate from and delivers a substrate to transfer station 27.

The four carrier head systems 70a-70d are mounted on carousel support plate 66 at equal angular intervals about carousel axis 64. Center post 62 allows the carousel motor to rotate carousel support plate 66 and to orbit carrier head systems 70a-70d and the substrates attached thereto about carousel axis 64.

Each carrier head system 70a-70d includes a carrier or carrier head 80. Each carrier head 80 independently rotates about its own axis. A carrier drive shaft 74 connects a carrier head rotation motor 76 (shown by the removal of one quarter of cover 68) to carrier head 80. There is one carrier drive shaft and motor for each head. In addition, each carrier head 80 independently laterally oscillates in a radial slot 72 formed in carousel support plate 66. A slider (not shown) supports each drive shaft 74 in radial slot 72. A radial drive motor (not shown) may move the slider to laterally oscillate the carrier head.

The carrier head 80 performs several mechanical functions. Generally, the carrier head holds the substrate against the polishing pad, evenly distributes a downward pressure across the back surface of the substrate, transfers torque from the drive shaft to the substrate, and ensures that the substrate does not slip out from beneath the carrier head during polishing operations.

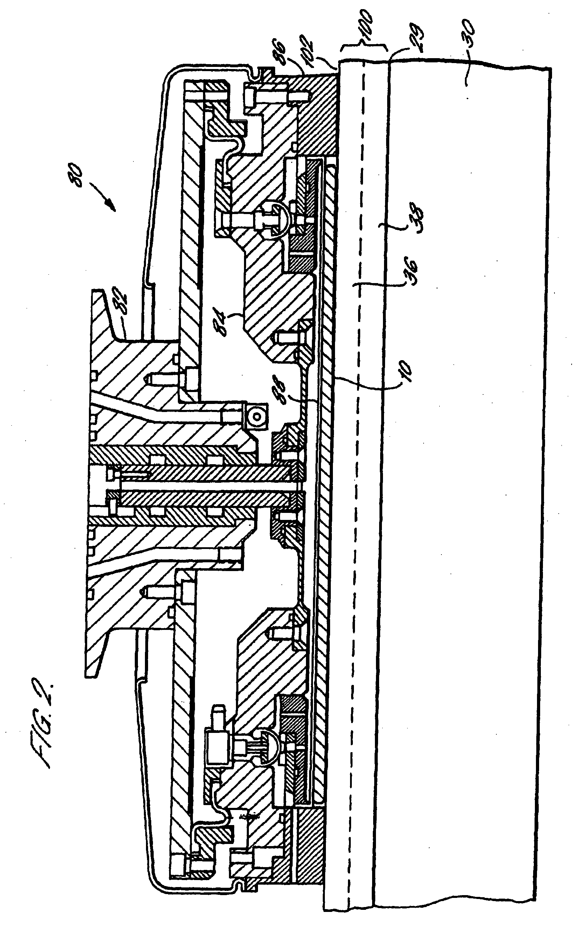

Referring to FIG. 2, each carrier head 80 includes a housing assembly 82, a base assembly 84 and a retaining ring assembly 86. A loading mechanism may connect base assembly 84 to housing assembly 82. The base assembly 84 may include a flexible membrane 88 which provides a substrate receiving surface for the carrier head. A description of carrier head 80 may be found in U.S. Patent Application Serial No. 08/745,679, entitled A CARRIER HEAD WITH A FLEXIBLE MEMBRANE FOR A CHEMICAL MECHANICAL POLISHING SYSTEM, filed November 8, 1996, by Steven M. Zuniga et al., assigned to the assignee of the present invention.

Polishing pad 100 may comprise a composite material having a roughened polishing surface 102. Polishing pad 100 may have an upper layer 36 and a lower layer 38. Lower layer 38 may be attached to platen 30 by a pressure-sensitive adhesive layer 39. Upper layer 36 may be harder than lower layer 38. Upper layer 36 may be composed of polyurethane or polyurethane mixed with a filler. Lower layer 38 may be composed of compressed felt fibers leached with urethane. A two-layer polishing pad, with the upper layer composed of IC-1000 and the lower layer composed of SUBA-4, is available from Rodel, Inc. of Newark, Delaware (IC-1000 and SUBA-4 are product names of Rodel, Inc.).

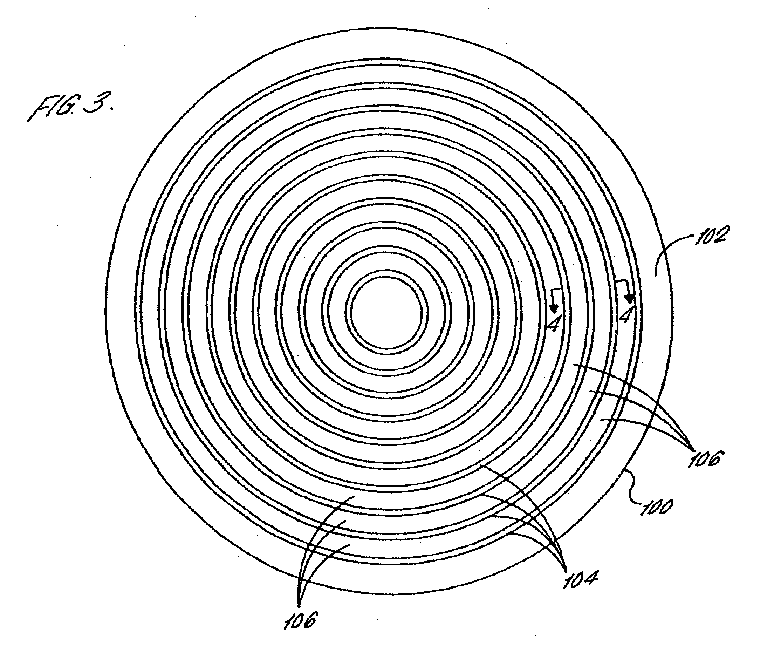

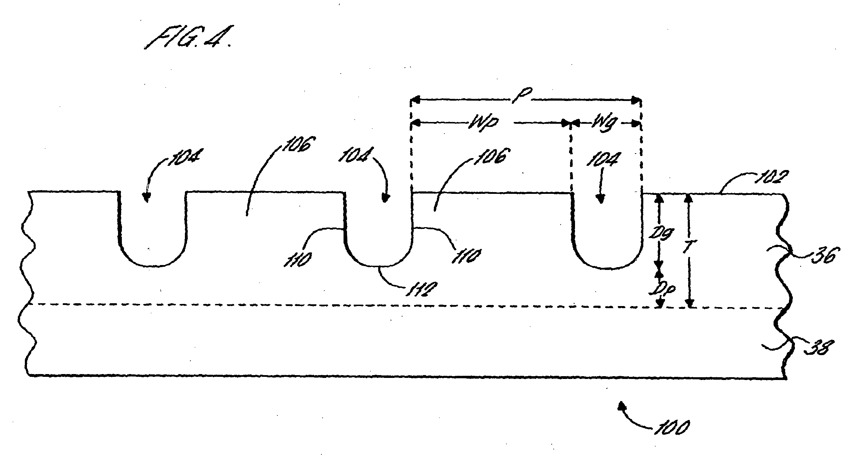

Referring to FIGS. 3 and 4, a plurality of concentric circular grooves 104 are disposed in polishing surface 102 of polishing pad 100. Advantageously, these grooves are uniformly spaced with a pitch P. The pitch P, as shown mostly clearly by FIG. 4, is the radial distance between adjacent grooves. Between each groove is an annular partition 106 having a width Wp. Each groove 104 includes walls 110 which terminate in a substantially U-shaped base portion 112. Each groove may have a depth Dg and a width Wg. Alternately, the grooves may have a rectangular cross-section.

The walls 110 are generally perpendicular and may terminate at U-shaped base 112. Each polishing cycle results in wear of the polishing pad, generally in the form of thinning of the polishing pad as polishing surface 102 is worn down. The width Wg of a groove with perpendicular walls 110 does not change as the polishing pad is worn. Thus, the generally perpendicular walls ensure that the polishing pad has a substantially uniform surface area over its operating lifetime.

The various embodiments of the polishing pad include wide and deep grooves in comparison to those used in the past. The grooves 104 have a minimum width Wg of about 0.38 mm (0.015 inches). Each groove 104 has a width Wg between about 0.38 and 1.0 mm (0.015 and 0.04 inches). Specifically, the grooves may have a width Wg of approximately 0.50 mm (0.020 inches). Each partition 106 may have a width Wp between about 1.9 and 5.1 mm (0.075 and 0.20 inches). Specifically, the partitions may have a width Wp of approximately 2.5 mm (0.10 inches). Accordingly, the pitch P between the grooves is between about 2.3 and 6.1 mm (0.09 and 0.24 inches). Specifically, the pitch may be approximately 3.0 mm (0.12 inches).

The ratio of groove width Wg to partition width Wp is selected to be between about 0.10 and 0.25. The ratio may be approximately 0.2. If the grooves are too wide, the polishing pad will be too flexible, and the "planarizing effect" will occur. On the other hand, if the grooves are too narrow, it becomes difficult to remove waste material from the grooves. Similarly, if the pitch is too small, the grooves will be too close together and the polishing pad will be too flexible. On the other hand, if the pitch is too large, slurry will not be evenly transported to the entire surface of the substrate.

The grooves 104 also have a depth Dg of at least about 0.50 mm (0.02 inches). The depth Dg is between about 0.50 and 1.3 mm (0.02 and 0.05 inches). Specifically, the depth Dg of the grooves is approximately 0.76 mm (0.03 inches). Upper layer 36 may have a thickness T between about 1.5 and 3.0 mm (0.06 and 0.12 inches). As such, the thickness T may be about 1.8 mm (0.07 inches). The thickness T is selected so that the distance Dp between the bottom of base portion 112 and lower layer 38 is between about 0.59 and 2.2 mm (0.035 and 0.085 inches). Specifically, the distance Dp may be about 1.0 mm (0.04 inches). If the distance Dp is too small, the polishing pad will be too flexible. On the other hand, if the distance Dp is too large, the polishing pad will be thick and, consequently, more expensive. Other embodiments of the polishing pad may have grooves with a similar depth.

Referring to FIG. 3, grooves 104 form a pattern defining a plurality of annular islands or projections. The surface area presented by these islands for polishing is between about 90% and 75% of the total surface area of polishing pad 100. As a result, the surface tension between the substrate and the polishing pad is reduced, facilitating separation of the polishing pad from the substrate at the completion of a polishing cycle.

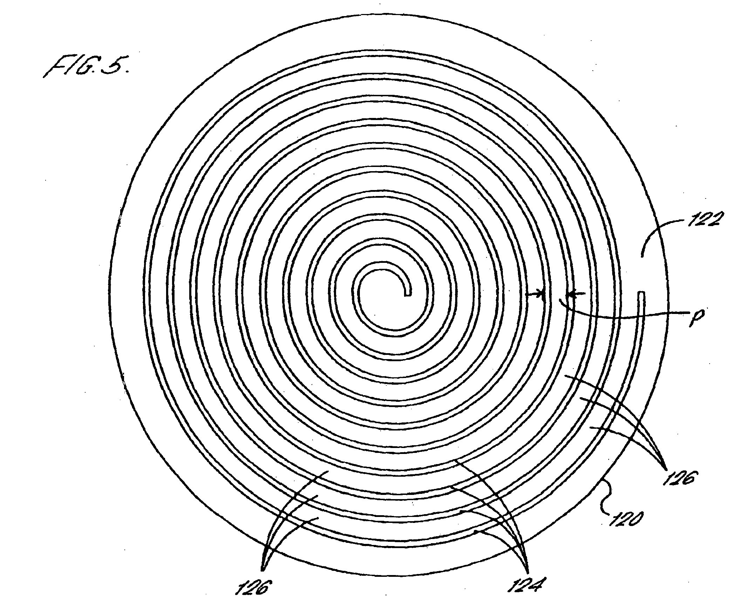

Referring to FIG. 5, in another embodiment, a spiral groove 124 is disposed in a polishing surface 122 of a polishing pad 120. Advantageously, the groove is uniformly spaced with a pitch P. A spiral partition 126 separates the rings of the spiral. Spiral groove 124 and spiral partition 126 may have the same dimensions as circular groove 104 and circular partition 106 of FIG. 3. That is, spiral groove 124 may have depth of at least about 0.50 mm (0.02 inches), a width of at least about 0.38 mm (0.015 inches), and a pitch of at least about 2.3 mm (0.09 inches). Specifically, spiral groove 124 may have a depth between 0.50 and 1.3 mm (0.02 and 0.05 inches), such as 0.76 mm (0.03 inches), a width between about 0.38 and 10 mm (0.015 and 0.40 inches), such as 5.1 mm (0.20 inches), and a pitch P between about 2.3 and 6.1 mm (0.09 and 0.24 inches), such as 3.0 mm (0.12 inches).

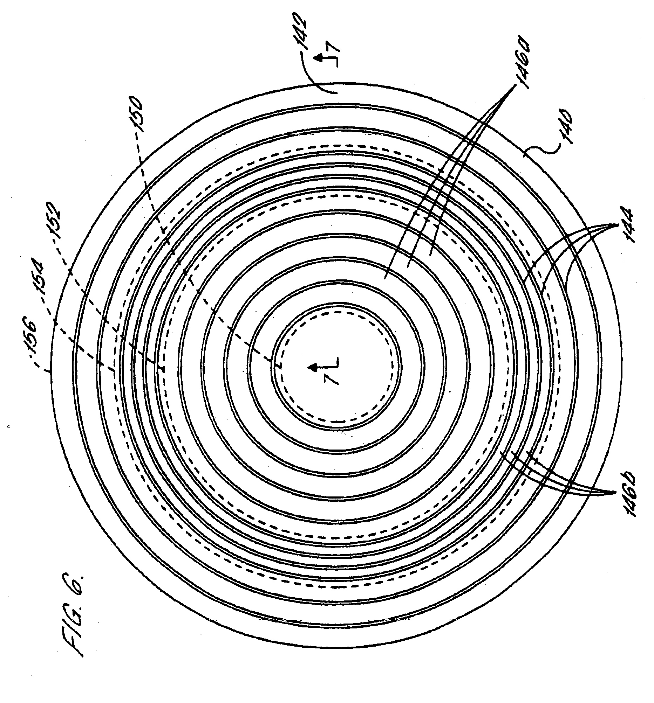

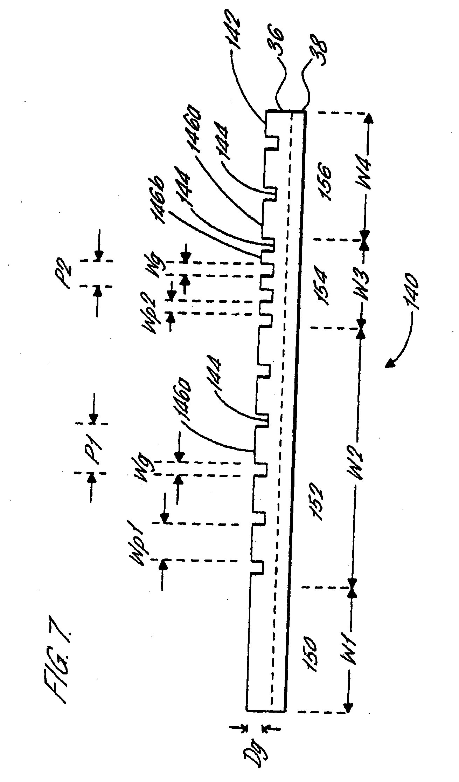

Referring to FIGS. 6 and 7, in another embodiment, a plurality of concentric circular grooves 144 are disposed in a polishing surface 142 of a polishing pad 140. However, these grooves are not uniformly spaced. Rather, polishing surface 142 is partitioned into regions in which the grooves are spaced apart with different pitches. In addition, the grooves do not necessarily have a uniform depth.

In one implementation, polishing surface 142 is divided into four concentric regions including an innermost region 150, an annular outermost region 156 and two intermediate regions 152 and 154. Region 150 may be constructed without grooves, and the grooves in region 154 may be more closely spaced than the grooves in regions 152 and 156. Thus, the grooves in the region 154 are spaced apart with a pitch P2, whereas the grooves in regions 152 and 156 are spaced apart with a pitch P1, where P2 is less than P1. Each groove 144 may have a width Wg. The width Wg may be between about 0.38 and 1.0 mm (0.015 and 0.04 inches), such as about 0.50 mm (0.02 inches). The grooves may also have a uniform depth Dg of about 0.50 mm (0.02 inches) for a 1.3 mm (0.05 inch) thick upper layer 36, or about 0.76 mm (0.03 inches) for a 2.0 mm (0.08 inch) thick upper layer.

Between each groove in wide-pitch regions 152 and 156 is a wide annular partition 146a having a width Wp1, whereas between each groove in narrow-pitch region 154 is an narrow annular partition 146b having a width Wp2. Each wide partition 146a may have a width Wp1 between about 3.0 and 6.1 mm (0.12 and 0.24 inches), such as about 4.6 mm (0.18 inches). Accordingly, the pitch P1 between the grooves in the wide partition regions may be between about 2.3 and 6.1 mm (0.09 and 0.24 inches), such as 5.1 mm (0.2 inches). Thus, pitch P1 may be about twice as large as pitch P2. The surface area presented by wide partitions 146a is about 90% of the available surface area of the wide partition regions.

As previously noted, the grooves in region 154 may be spaced closer together. Each narrow partition 146b may have a width Wp2 between about 1.0 and 3.0 mm (0.04 and 0.12 inches), such as about 2.0 mm (0.08 inches). Accordingly, the pitch P2 between the grooves in the narrow partition region may be between about 1.1 and 5.1 mm (0.045 and 0.2 inches), such as 2.5 mm (0.10 inches). The surface area presented by narrow partitions 146b is about 75% of the available surface area of the narrow partition region.

Polishing pad 140 is particularly suited to reduce polishing uniformity problems, such as the so-called "fast band" effect. The fast band effect tends to appear in oxide polishing using a two-layer polishing pad with an SS12 slurry containing fumed silicas. The fast band effect causes an annular region of the substrate, the center of which is located approximately 15 millimeters from the substrate edge, to be significantly over-polished. This annular region may be about 20 millimeters wide. If polishing pad 140 is constructed to counter the fast band effect, the first region 150 may have a radius W1 of about 81 mm (3.2 inches), the second region 152 may have a width W2 of about 120 mm (4.8 inches), the third region 154 may have a width W3 of about 30 mm (1.2 inches), and the fourth region 156 may have a width W4 of about 20 mm (0.8 inches). These widths assume that the polishing pad is about 500 mm (20 inches) in diameter, and that the substrate will be moved across the polishing pad surface with a sweep range of about 20 mm (0.8 inches), so that the substrate will be about 5.1 mm (0.2 inches) from the edge of the pad at the outermost point of the sweep and about 25 mm (1.0 inches) from the center of the pad at the innermost point of the sweep.

It appears that the polishing rate is comparable to the percentage of polishing pad surface area that contacts the substrate during polishing. By providing the polishing pad with a region in which more surface area is occupied by the grooves, the polishing rate is reduced in that region. Specifically, the closely spaced grooves in region 154 decrease the polishing rate in the otherwise over-polished portions of the substrate. Consequently, the polishing pad compensates for the fast band effect and improves polishing uniformity.

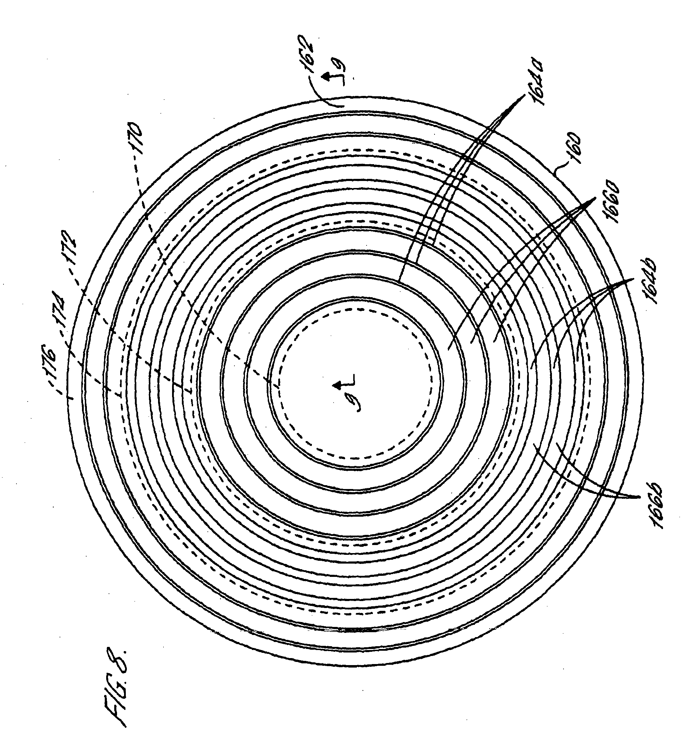

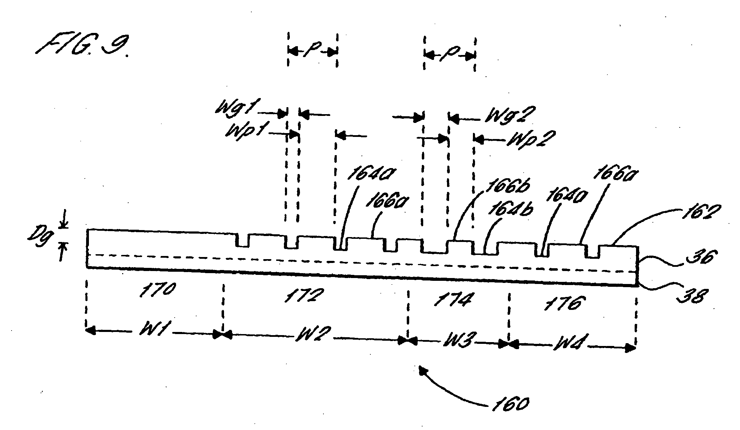

In another embodiment, referring to FIGS. 8 and 9, a plurality of concentric circular grooves 164a and 164b are disposed in a polishing surface 162 of a polishing pad 160. These grooves 164a and 164b may be uniformly spaced with a pitch P. However, the grooves do not have a uniform width.

In one implementation, polishing surface 162 is divided into four concentric regions, including an innermost region 170, an outermost region 176, and two intermediate regions 172 and 174. Region 170 may be constructed without grooves, and the grooves 164b in region 174 may be wider than the grooves 164a in regions 172 and 176. The narrow grooves 164a may have a width Wg1 whereas the wide grooves 164b may have a width Wg2. Between each narrow groove 164a is a wide annular partition 166a having a width Wp1, whereas between each wide groove 164b is a narrow annular partition 166b having a width Wp2.

The wide grooves may be approximately two to twenty times, e.g., six times, wider than the narrow grooves. The narrow grooves 164a may have a width Wg1 between about 0.38 and 1.0 mm (0.015 and 0.04 inches), such as 0.50 mm (0.02 inches), whereas the wide grooves 164b may have a width Wg2 between about 1.0 and 7.6 mm (0.04 and 0.3 inches), such as 3.2 mm (0.125 inches). The wide partitions 166a may have a width Wp1 of between about 2.5 and 9.8 mm (0.10 and 0.385 inches), such as 4.6 mm (0.18 inches), whereas the narrow partitions 166b may have a width Wp2 between about 1.3 and 2.5 mm (0.05 and 0.10 inches), such as 1.9 mm (0.075 inches). The grooves may be evenly spaced with a pitch P between about 2.3 and 10 mm (0.09 and 0.40 inches), such as 5.1 mm (0.2 inches). In the narrow groove regions 172 and 176, the partitions cover about 75% of the available surface area whereas in the wide-grooved region 174 the partitions cover about 50% of the available surface area.

It should be noted that a variety of groove widths and/or spacings may be used to achieve the desired contact surface area. The key factor is that there be less surface area to contact the portions of the substrate which would otherwise be overpolished. A polishing pad having non-uniform groove spacings and widths may also be useful in processes in which nonuniform polishing of a substrate is desired.

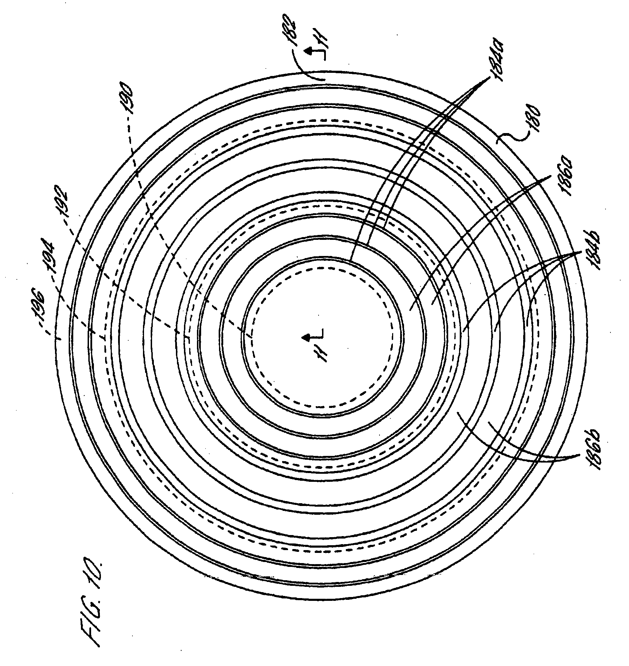

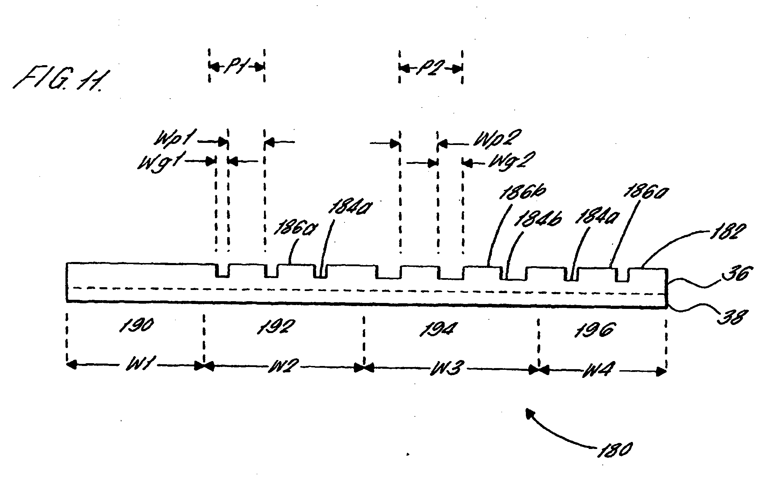

In another embodiment, referring to FIGS. 10 and 11, a plurality of concentric circular grooves 184a and 184b are disposed in a polishing surface 184 of a polishing pad 180. These grooves 184a and 184b have both a non-uniform pitch and a non-uniform width.

In one implementation, polishing surface 182 is divided into four concentric regions, including an innermost region 190, an outermost region 196, and two intermediate regions 192 and 194. Region 190 may be constructed without grooves, and grooves 184b in region 194 may be wider but spaced farther apart than grooves 184a in regions 192 and 196. The narrow grooves 184a may have a width Wg1 of about 0.5 mm (0.02 inches), whereas wide grooves 184b may have a width Wg2 of about 3.2 mm (0.125 inches). The narrow grooves 184a may be disposed with a pitch P1 of about 3.0 mm (0.12 inches), whereas wide grooves 184b in region 194 may be disposed with a pitch P2 of about 5.1 mm (0.2 inches). Between each narrow groove 184a is an annular partition 186a having a width Wp1 of about 2.5 mm (0.1 inches), whereas between each wide groove 184b is a annular partition 186b having a width Wp2 of about 1.9 mm (0.075 inches).

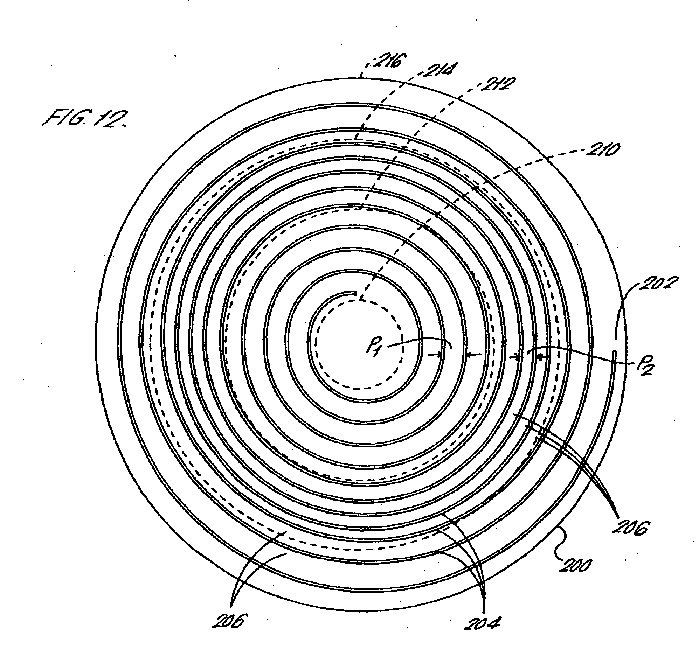

Referring to FIG. 12, in another embodiment, a spiral groove 204 is disposed in a polishing surface 202 of a polishing pad 200. A spiral partition 206 separates the rings of the spiral. The groove 204 has a non-uniform pitch. The width of groove 204 may be uniform or non-uniform.

Polishing surface 202 may be divided into four concentric regions, including an innermost region 210, an outermost region 216, and two intermediate regions 212 and 214. In region 214 the spiral groove has a narrower pitch than in regions 212 and 216. Specifically, spiral groove 204 may have a pitch P1 of about 5.1 mm (0.20 inches) in regions 212 and 216, and a pitch P2 of about 3.0 mm (0.12 inches) in region 214. Spiral groove 204 does not extend into region 210.

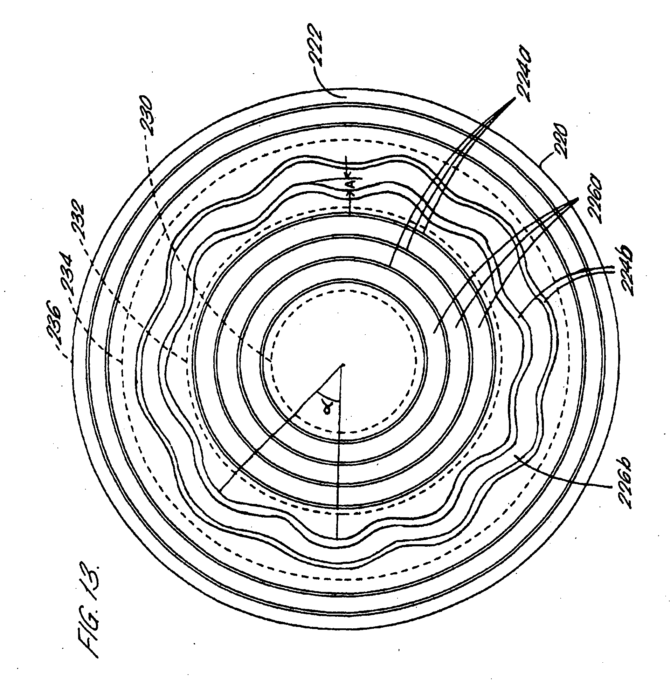

Referring to FIG. 13, in another embodiment, a plurality of concentric circular grooves 224a and a plurality of serpentine grooves 224b are disposed in a polishing surface 224 of a polishing pad 220. Serpentine grooves 224b may be wider than circular grooves 224a. Between each circular groove 224a is an annular partition 226a, whereas between each serpentine groove 224b is a serpentine partition 226b. Although not illustrated, some of the serpentine grooves 224b may intersect some of the circular grooves 224a.

Polishing surface 222 may be divided into four concentric regions, including an innermost region 230, an outermost region 236, and two intermediate regions 232 and 234. Region 230 may be constructed without grooves, whereas serpentine grooves may be located in region 234, and circular grooves may be located in regions 232 and 236. Circular grooves 224a may be constructed with a width of about 0.50 mm (0.02 inches) and a pitch of about 3.0 mm (0.12 inches). Each serpentine grooves 224b may undulate between its innermost.an outermost radius with an amplitude A of about 2.5 to 13 mm (0.1 to 0.5 inches), such as 5.1 or 10 mm (0.2 or 0.4 inches). Each undulation of a serpentine groove may extend through an angle α between about 5 and 180 degrees, such as 15 degrees. Thus, each serpentine grooves 224b may have between about 2 and 72, e.g., 24, undulations. The serpentine grooves 224b may have a width of about 3.2 mm (0.125 inches) and a pitch of about 5.1 mm (0.20 inches). The second pitch of serpentine grooves 224 may be between about one and two times their amplitude, or between about one-and-one-half and two times their second width.

In an exemplary polishing pad, region 232 may extend from a radius of about 81 mm (3.2 inches) to a radius of about 200 mm (8.0 inches), region 234 may extend from a radius of about 200 mm (8.0 inches) to a radius of about 230 mm (9.2 inches), and region 236 may extend from a radius of about 230 mm (9.2 inches) to a radius of about 250 mm (9.92 inches).

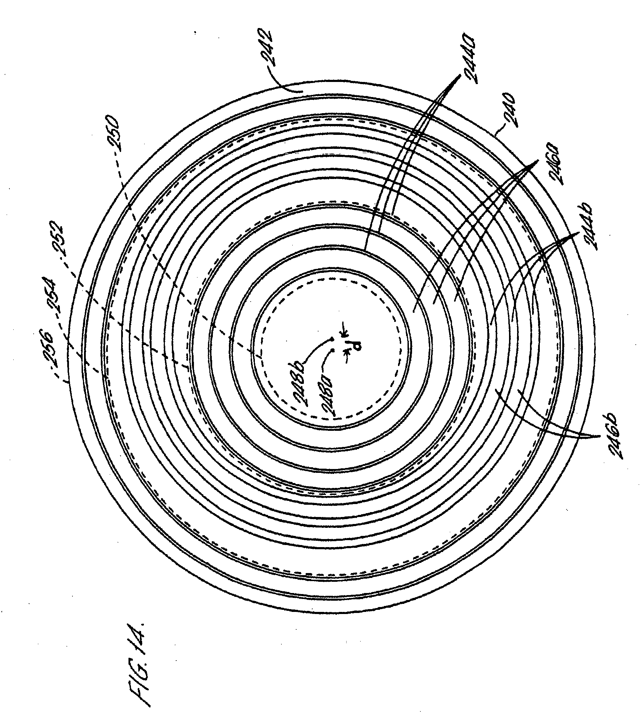

Referring to FIG. 14, in still another embodiment, circular grooves 244a and 244b are disposed in a polishing surface 242 of a polishing pad 240. These grooves have non-uniform widths. In addition, grooves 244a are concentric about a point 248a, whereas grooves 224b are concentric about a different point 248b. Grooves 244a are separated by annular partitions 246a, whereas grooves 244b are separated by annular partitions 246b. The center points 248a and 248b may be separated by a distance d approximately equal to the pitch between grooves 244b. Although not illustrated, some of the circular grooves 244a may intersect some of the circular grooves 244b.

Polishing surface 242 is divided into four concentric regions including an innermost region 250, an outermost region 256, and two intermediate regions 252 and 254. The grooves in regions 252 and 256 are concentric about point 248a, whereas the grooves in region 254 are concentric about point 248b. Grooves 244a and 244b may have widths of 0.50 and 3.2 mm (0.02 and 0.125), respectively, and pitches of 5.1 and 6.1 mm (0.20 and 0.24), respectively.

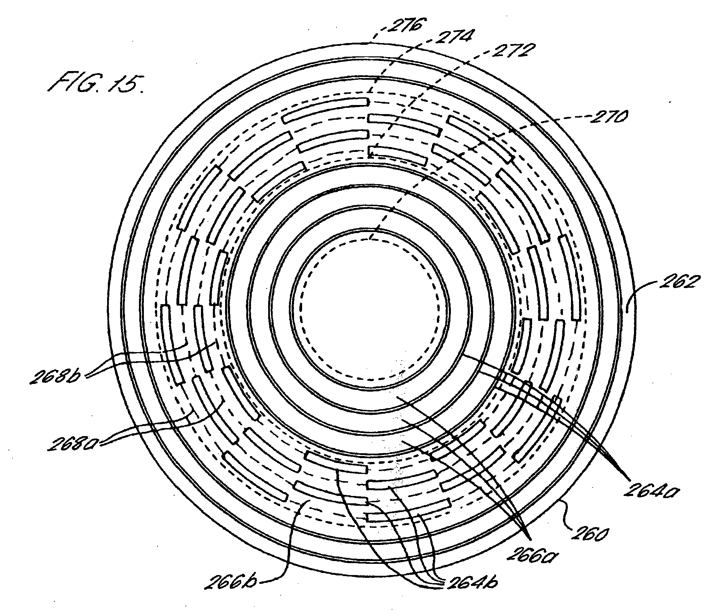

Referring to FIG. 15, in yet another embodiment, a plurality of concentric circular grooves 264a and a plurality of segmented groove arcs 264b are formed in a polishing surface 262 of a polishing pad 260. The segmented groove arcs 264b are disposed along adjacent concentric circular paths 268a and 268b. The arcs may be offset so that the arcs on paths 268a are not adjacent to the arcs on paths 268b. An annular partition 266a separates each circular groove 264a, whereas a single partition 266b encompasses groove arcs 264b.

Polishing surface 262 may be divided into four concentric regions, including an innermost region 270, an outermost region 276, and two intermediate regions 272 and 274. Region 270 may be constructed without grooves, whereas groove arcs 264b may be located in region 274 and circular grooves 264a may be located in regions 272 and 276. Circular grooves 264a may have a width of about 0.51 mm (0.02 inches) and a pitch of about 5.1 mm (0.20 inches). Groove arcs 264b may have a width of about 3.2 mm (0.125 inches), and circular paths 268a and 268b may be spaced apart by about 5.1 mm (0.2 inches). In this embodiment, the pitch may be considered as the between adjacent circular paths.

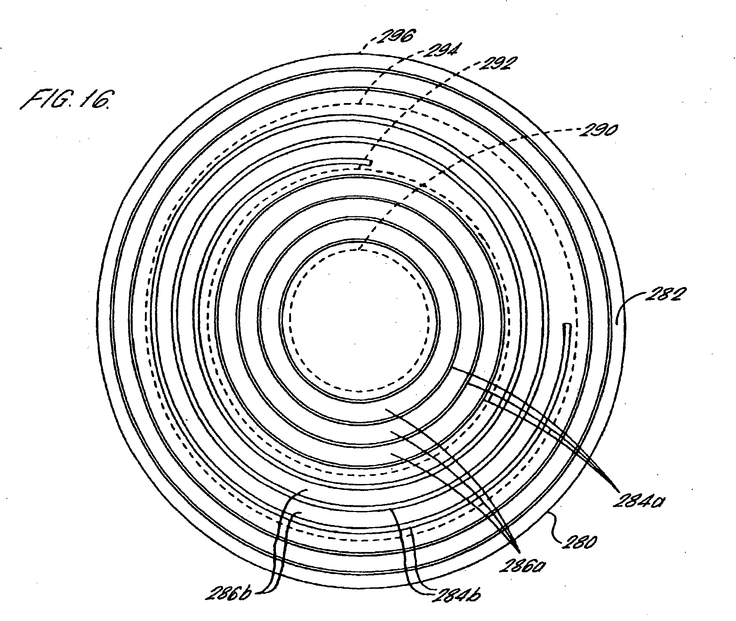

Referring to FIG. 16, in still another embodiment, a plurality of concentric circular grooves 284a and a spiral groove 284b are formed in a polishing surface 282 of a polishing pad 280. An annular partition 286a separates each circular groove 284a, whereas spiral groove 284b defines a spiral partition 286b.

Polishing surface 282 may be divided into four concentric regions, including an innermost region 290, an outermost region 296, and two intermediate regions 292 and 294. Region 290 may be constructed without grooves, whereas spiral groove 284b may be located in region 294 and circular grooves 284a may be located in regions 292 and 296. Circular grooves 284a may be constructed similarly to circular grooves 264a, i.e., with a width of about 0.50 mm (0.02 inches) and a pitch of about 3.0 mm (0.12 inches). Spiral groove 284b may have a width of about 3.2 mm (0.125 inches), and a pitch of about 5.1 mm (0.2 inches). In an exemplary polishing pad, region 282 may extend from a radius of about 81 mm (3.2 inches) to a radius of about 200 mm (7.88 inches), region 284 may extend from a radius of about 200 mm (8.0 inches) to a radius of about 230 mm (9.2 inches) and region 286 may extend from a radius of about 240 mm (9.32 inches) to a radius of about 250 mm (9.92 inches).

In addition, in all of the embodiments, there may be gradients of groove width and/or partition width between adjacent regions. These gradients provide polishing at rates intermediate to the rates in the adjacent regions. Since the substrate is oscillated across the polishing pad surface, the intermediate polishing rates will provide more uniform polishing between adjacent areas of the substrate.

The grooves of the embodiments described above provide air channels which reduce any vacuum build-up between the polishing pad and the substrate. However, as the surface area available for polishing decreases, an accompanying increase in the polishing time may be required to achieve the same polishing results.

The grooves may be formed in the polishing surface by cutting or milling. Specifically, a saw blade on a mill may be used to cut grooves in the polishing surface. Alternatively, grooves may be formed by embossing or pressing the polishing surface with a hydraulic or pneumatic press. The relatively simple groove pattern avoids expensive machining. Also, the grooves may be formed by preparing the polishing pad in a mold. For example, the grooves may be formed during a polymerization reaction in which the polishing pad is cast from a mold which contains a negative image of the grooves.

As was described above, the slurry/rinse arm provides slurry to the polishing surface. The continuous channels formed in the polishing pad facilitate the migration of slurry around the polishing pad. Thus, excess slurry in any region of the pad may be transferred to another region by the groove structure, providing more uniform coverage of slurry over the polishing surface. Accordingly, the distribution of slurry is improved and any variations in the polishing rate attributable to poor slurry distribution will be reduced.

In addition, the grooves reduce the possibility that waste materials generated during the polishing and conditioning cycles will interfere with slurry distribution. The grooves facilitate the migration of waste materials away from the polishing pad surface, reducing the possibility of clogging. The width of the grooves permits a spray rinse from slurry/rinse arm 52 to effectively flush the waste materials from the grooves.

The depth of the grooves improves polishing pad lifetime. As discussed above, the conditioning process abrades and removes material from the surface of the polishing pad, thereby reducing the depth of the grooves. Consequently, the lifetime of the pad may be increased by increasing the groove depth.

## Claims

1. A polishing pad (100) for polishing a substrate in a chemical mechanical polishing system, comprising a polishing surface (102) suitable for integrated circuit fabrication having a first plurality of substantially circular grooves (104) **characterised in that**: the grooves have a depth between about 0.50 and 1.3mm (0.02 and 0.05 inches), a width between about 0.38 and 1.0mm (0.015 and 0.04 inches), and a pitch of between about 2.3 and 6.1mm (0.09 and 0.24 inches); and each of the grooves has side walls that are perpendicular to the polishing surface; wherein the grooves are separated by partitions, and the ratio of the width of the grooves to the partitions is between about 0.10 and 0.25; and wherein the pad has an upper layer providing said polishing-surface and a lower layer adapted to mount the pad, the distance (Dp) between the bottom of the groove and the lower layer being between about 0.89mm and 2.2mm (0.035 inches and 0.085 inches).

2. The polishing pad of claim 1, wherein the grooves having a depth of approximately 0.76mm (0.03 inches), a width of approximately 0.50mm (0.02 inches), and a pitch of approximately 3.0mm (0.12 inches).

3. The polishing pad of claim 1, wherein the upper layer has a thickness between about 1.5mm and 3.0mm (0.06 inches and 0.12 inches).

## Patentansprüche

1. Polierkissen (100) zum Polieren eines Substrats in einem chemischen mechanischen Poliersystem, wobei das Polierkissen eine für die Herstellung von integrierten Schaltungen geeignete Polierfläche (102) mit einer ersten Vielzahl von im Wesentlichen kreisförmigen Nuten (104) hat, **dadurch gekennzeichnet, dass** die Nuten eine Tiefe zwischen etwa 0,50 mm und 1,3 mm (0,02 und 0,05 Zoll), eine Breite zwischen etwa 0,38 und 1,0 mm (0,015 und 0,04 Zoll) und eine Teilung zwischen etwa 2,3 und 6,1 mm (0,09 und 0,24 Zoll) haben, und dass jede der Nuten Seitenwände hat, die senkrecht zu der Polierfläche sind, wobei die Nuten durch Trennwände getrennt sind und das Verhältnis der Breite der Nuten zu den Trennwänden zwischen etwa 0,10 und 0,25 liegt, und wobei das Kissen eine obere Schicht, die die Polierfläche bildet, und eine untere Schicht aufweist, die für das Halten des Kissens ausgelegt ist, wobei der Abstand (Dp) zwischen dem Boden der Nut und der unteren Schicht zwischen etwa 0,89 mm und 2,2 mm (0,035 Zoll und 0,085 Zoll) liegt.

2. Polierkissen nach Anspruch 1, bei welchem die Nuten eine Tiefe von etwa 0,76 mm (0,03 Zoll), eine Breite von etwa 0,50 mm (0,02 Zoll) und eine Teilung von etwa 3,0 mm (0,12 Zoll) haben.

3. Polierkissen nach Anspruch 1, bei welchem die obere Schicht eine Dicke zwischen etwa 1,5 mm und 3,0 mm (0,06 Zoll und 0,12 Zoll) aufweist.

## Revendications

1. Tampon de polissage (100) destiné à polir un substrat dans un système de polissage chimique et mécanique, comportant une surface de polissage (102) convenant à la fabrication de circuits intégrés ayant une première pluralité de rainures sensiblement circulaires (104), **caractérisé en ce que** : les rainures ont une profondeur comprise entre environ 0,50 mm et 1,3 mm (0,02 inch et 0,05 inch), une largeur comprise entre environ 0,38 mm et 1 mm (0,015 inch et 0,04 inch) et un pas compris entre 2,3 et 6,1 mm (0,09 et 0,24 inch) ; et chacune des rainures a des parois latérales qui sont perpendiculaires à la surface de polissage ; dans lequel les rainures sont séparées par des cloisons, et le rapport de la largeur des rainures à celle des cloisons est compris entre environ 0,10 et 0,25 ; et dans lequel le tampon comporte une couche supérieure fournissant ladite surface de polissage et une couche inférieure adaptée pour le montage du tampon, la distance (Dp) entre le fond de la rainure et de la couche inférieure étant comprise entre environ 0,89 mm et 2,2 mm (0,035 inch et 0,085 inch).

2. Tampon de polissage selon la revendication 1, dans lequel les rainures ont une profondeur d'environ 0,76 mm (0,03 inch), une largeur d'environ 0,50 mm (0,02 inch) et un pas d'environ 3,0 mm (0,12 inch).

3. Tampon de polissage selon la revendication 1, dans lequel la couche supérieure a une épaisseur comprise entre environ 1,5 et 3,0 mm (0,06 et 0,12 inch).
